# EUROPEAN PATENT APPLICATION

(11) **EP 2 058 119 A2**
(43) Date of publication of application: **13.05.2009**
(21) Application number: 08019481.4
(22) Date of filing: 07.11.2008
(51) Int. Cl.: B32B 18/00, C04B 37/00

(54) **Ceramic sheet and producing method thereof**

(30) Priority: 07.11.2007 JP 2007289817
(71) Applicant: Kitagawa Industries Co., Ltd., Nagoya-shi, Aichi-ken 460-0012 (JP)
(72) Inventor: Kawai, Hideharu, Nagaoy-shi, Aichi-ken, 460-0012 (JP); Matsuzaki, Toru, Nagaoy-shi, Aichi-ken, 460-0012 (JP)
(74) Representative: Vogler, Bernd

(57) **Abstract**

A ceramic sheet has at least one ceramic layer. The at least one ceramic layer includes a plurality of ceramic pieces, at least a part of the plurality of ceramic pieces is formed by cracking a sintered ceramic plate, which at least partially has a flat part, at the flat part of the sintered ceramic plate.

## Description

### BACKGROUND

This invention relates to a ceramic sheet including at least one ceramic layer.

A conventional ceramic sheet including a layer containing a plurality of ceramic pieces arranged in a planar manner has already been proposed, for example, in Unexamined Japanese Patent Publication No. 2006-315368. In the paragraphs, such as [0036]-[0037], of this Publication, a method of arranging a plurality of ceramic pieces in a planar manner is disclosed. In this method, a plurality of linear slits which are parallel to each other in one direction are produced on at least one side of a green sheet containing ceramic. The green sheet is then sintered to form a sintered body. Thereafter, the sintered body placed on a sheet is broken into a plurality of blocks at the portions where the slits were made.

If the ceramic pieces are produced as such, sections around the slits of the green sheet shrink more than the other sections due to sintering reaction. Thus, non-contact surfaces which do not come to contact with the adjacent blocks can be easily formed. According to the paragraph [0048] of the above Publication, such non-contact surfaces allow to inhibit concentration of stress on corners of the blocks.

### SUMMARY

In the aforementioned ceramic sheet, the sintered body is split into a plurality of square blocks along the linear slits that have been produced. Therefore, when the ceramic sheet is disposed along, for example, a curve of a cylinder, it is relatively easy to bend the ceramic sheet in a direction such that the slits are parallel to a center axis of the cylinder.

On the other hand, it is not easy to bend the aforementioned ceramic sheet in a direction in which the slits and the center axis of the cylinder are not parallel, that is, a direction in which the slits and the center axis of the cylinder are skew to each other, neither parallel nor intersecting. Hence, when the ceramic sheet is forced to be bent in such direction, the corners of the square blocks sometimes break through the film on the surface layer side.

That is, operation of disposing the aforementioned ceramic sheet along a curve is not always easy. The operation requires sufficient attention to the bent direction of the ceramic sheet.

Also, in the aforementioned ceramic sheet, if the non-contact surface as above is formed on each of the ceramic blocks, a contact area between the adjacent ceramic blocks is decreased. Thus, continuity in the ceramic layer is interrupted, which also impairs the performance of the ceramic layer.

As noted above, the technique disclosed in the above Publication may be effective in the case of emphasizing not to concentrate stress on the corner of each ceramic block. However, it is difficult for the technique to sufficiently improve the performance of the ceramic layer.

In one aspect of the present invention, it would be desirable to provide a ceramic sheet which can reduce labor to pay attention to a bending direction of the ceramic sheet and which can further improve performance of the ceramic layer than before.

A ceramic sheet in a first aspect of the present invention has at least one ceramic layer. The at least one ceramic layer includes a plurality of ceramic pieces. At least a part of the plurality of ceramic pieces is formed by cracking a sintered ceramic plate, which at least partially has a flat part, in at the flat part of the sintered ceramic plate.

The flat part of the sintered ceramic plate is cracked in irregular directions. In the portions of the at least one ceramic layer where the ceramic plate was cracked in the irregular directions, the bending direction is not fixed to a certain direction.

Accordingly, without paying excessive attention to the bending direction, the ceramic sheet of the present invention can be easily disposed to follow a curve.

Also, the ceramic pieces produced by cracking the flat part of the sintered ceramic plate are not shrunk at the outer edges. Thus, even if microscopic unevenness is produced on fracture cross sections (outer edges of the ceramic pieces), the adjacent ceramic pieces can fit into each other. Accordingly, there is almost no gap or, if there is, only a very little gap exists and not an excessive gap is produced between the adjacent ceramic pieces. Hence, continuity in the ceramic layer is not interrupted. The performance of the ceramic layer can be improved.

Moreover, in the ceramic sheet disclosed in the above Publication, a contact area between the ceramic pieces is narrowed by the shrink at the slits. In at least a part of the ceramic sheet of the present invention, such slits are not produced. In the at least the part of the ceramic sheet, the thickness of the ceramic plate is effectively utilized to maximize the contact area between the ceramic pieces. Accordingly, continuity in the ceramic layer is not interrupted. The performance of the ceramic layer can be improved.

When slits are artificially produced on a sintered body as in the ceramic sheet of the above Publication, the sintered body is not always split at the fragile parts of the sintered body. Thus, when external shock is applied to the ceramic sheet, the ceramic block may sometimes split at a part other than the slits, thereby causing alteration to the properties of the ceramic sheet.

The ceramic sheet of the present invention does not require to form slits on the ceramic plate to produce irregular cracks. The desired irregular cracks can be produced by breaking fragile parts of the ceramic plate. Accordingly, as compared to a ceramic sheet containing ceramic pieces which may include unbroken fragile parts, further breaking of the individual ceramic pieces can be inhibited, thereby restricting alteration of the properties of the ceramic sheet.

The flat part may be a part having a constant thickness in the sintered ceramic plate or a part having no incision formed in the sintered ceramic plate.

Also, the plurality of ceramic pieces may be formed by sandwiching the sintered ceramic plate between at least two another layers and cracking the sintered ceramic plate by applying external force to the sintered ceramic plate, or by adhering the sintered ceramic plate to at least another layer and cracking the sintered ceramic plate by applying external force to the sintered ceramic plate.

If the ceramic plate is broken before stacking another layer on the ceramic plate, gaps between the ceramic pieces may be possibly expanded during the stack operation. Performance of the ceramic layer may be deteriorated. If much attention is paid for the stack operation so as to avoid performance deterioration, productivity may be decreased due to necessity of caution. The constitution of the present invention can inhibit production of gaps between the ceramic pieces without necessity of excessive caution. The performance of the ceramic layer can be improved without decreasing the productivity.

The plurality of ceramic pieces may be formed by cracking the sintered ceramic plate by causing the sintered ceramic plate to pass at least one roller such that external force is applied to at least one side of the sintered ceramic plate from the at least one roller.

The ceramic plate, as caused to pass the roller, is gradually cracked and broken into pieces. At this time, relatively small pieces are caused to pass the roller without being further broken, while excessively large pieces are further broken into smaller piece.

The ceramic sheet, including the ceramic layer which contains the ceramic pieces finely broken as such, can be easily bent to the extent of a curvature of the roller. Accordingly, by assuming a curvature of the ceramic sheet in use and selecting a roller having an adequate curvature, the ceramic sheet can be produced which is appropriate to be bent at a desired curvature.

An excessively large piece in the ceramic layer may break through the another layer when bending the ceramic sheet. However, as noted above, by assuming a curvature of the ceramic sheet in use and selecting a roller having an adequate curvature, the ceramic pieces can be inhibited from breaking through the another layer when bending the ceramic sheet at a desired curvature.

The sintered ceramic plate may be caused to pass the at least one roller more than once. In this case, the sintered ceramic plate may be caused to pass the at least one roller each time in different directions.

In this manner, the bending direction of the ceramic sheet can be set to various directions. The ceramic sheet can be easily bent to follow any types of curves along which the ceramic sheet is disposed.

The ceramic material may include at least one of Ni-Zn ferrite, Mn-Zn ferrite, Mg-Zn ferrite, Ba ferrite, ferroxplana ferrite, Cu-Zn ferrite, alumina, silicon carbide, barium titanate, aluminum nitride, boron nitride, silicon nitride, magnesia and graphite.

If the ceramic material includes at least one of Ni-Zn ferrite, Mn-Zn ferrite, Mg-Zn ferrite, Ba ferrite, ferroxplana ferrite or Cu-Zn ferrite, the ceramic sheet of the present invention exhibits excellent performance as a magnetic body. If the ceramic material includes at least one of alumina, silicon carbide or barium titanate, the ceramic sheet of the present invention exhibits excellent performance as a dielectric body. If the ceramic material includes at least one of aluminum nitride, boron nitride, silicon nitride, magnesia or graphite, the ceramic sheet of the present invention exhibits excellent performance as a heat-conductive body.

The ceramic sheet may have at least one another layer stacked on the at least one ceramic layer.

For example, the at least one another layer may include an adhesive layer made of adhesive material. In this case, if the outermost layer is the adhesive layer, the ceramic sheet can adhere and be fixed to other object by using the adhesive layer.

The adhesive layer may be an inner layer. In this case, layers on both sides of the adhesive layer are secured to the adhesive layer. If layers on both sides of the ceramic layer are the adhesive layers, the ceramic layer is covered by the adhesive layers from both sides. Even if fine pieces are produced when the ceramic layer is broken, the fine pieces are caught and held by the adhesive layers to stay near the fracture part of the ceramic layer. Since the fine pieces do not drop off or move to be displaced to one section, performance of the ceramic sheet is stable and can be easily maintained.

For example, the at least one another layer may include a conductive layer made of conductive material. In this case, the conductive layer functions as an electromagnetic wave shield. Due to synergetic effect of the ceramic layer and the conductive layer, effect of inhibiting radiated noise can be further advanced.

For example, the at least one another layer may include a heat-conductive layer made of heat-conductive material. In this case, the ceramic sheet can escape heat from the heat source to the radiation side by using the heat-conductive layer.

For example, the at least one another layer may include a damping layer made of damping material In this case, for example, when the ceramic sheet is disposed to come to contact with an electronic part, vibration transmitted to the electronic part can be eased and the electronic part can be protected. Elastomer material may be used as the damping material.

For example, the at least one another layer may include an impact-resistant layer made of impact-resistant material. In this case, for example, when the ceramic sheet is disposed to come to contact with an electronic part, damage to the electronic part can be inhibited when an impact is applied to the electronic part.

In the above, the structures are described in which the another layer has some function other than holding the ceramic layer. The ceramic sheet of the present invention may be a stacked structure including the ceramic layer, the another layer existing on either side or both sides of the ceramic layer, and some other layers. Accordingly, for example, the adhesive layer, conductive layer, heat-conductive layer, damping layer, impact-resistant layer and others may be added to a basic structure of either a three-layered structure having the ceramic layer and the another layer on each side of the ceramic layer or a two-layered structure having the ceramic layer adhering to the another layer.

A method of producing a ceramic sheet in a second aspect of the present invention is a method of producing a ceramic sheet having at least one ceramic layer. The method includes a step of forming the at least one ceramic layer including a plurality of ceramic pieces by cracking a sintered ceramic plate, which at least partially has a flat part, at at least the flat part of the sintered ceramic plate.

In other words, this method is a method of producing the ceramic sheet of the first aspect, and able to provide the ceramic sheet of the first aspect.

### BRIEF DESCRIPTION OF THE DRAWINGS

The invention will now be described below, by way of example, with reference to the accompanying drawings, in which:
FIG. 1A shows a perspective view of a ceramic sheet according to a first embodiment;
FIG. 1B shows an exploded view showing a structure of the ceramic sheet according to the first embodiment;
FIG. 2 shows an upper surface of a ceramic layer in the ceramic sheet according to the first embodiment as an example;
FIGS. 3A-3E show explanatory views illustrating a production process of the ceramic sheet according to the first embodiment;
FIG. 4 shows a cross sectional view of a ceramic sheet according to a second embodiment;
FIG. 5A shows a perspective view of a ceramic sheet according to a third embodiment;
FIG. 5B shows a perspective view showing a used state of the ceramic sheet according to the third embodiment;
FIG. 6A shows a perspective view of a ceramic sheet according to a fourth embodiment;
FIG. 6B shows a perspective view showing a used state of the ceramic sheet according to the fourth embodiment;
FIG. 7A shows an explanatory view of a ceramic sheet according to a fifth embodiment and a RFID (radio frequency identification) antenna base;
FIG. 7B shows an explanatory view showing a used state of the ceramic sheet according to the fifth embodiment;
FIG. 7C shows an explanatory view showing a used state of the ceramic sheet according to a variation of the fifth embodiment;
FIG. 8A shows a perspective view of an antenna according to a sixth embodiment;
FIG. 8B shows a perspective view of an antenna according to a seventh embodiment;
FIGS. 9A-9C show cross sectional views of a magnetic core according to a variation of the seventh embodiment; and
FIGS. 10A-10E show explanatory views illustrating a variation of the production process in the first embodiment.

### DETAILED DESCRIPTION OF THE PREFERRED

### EMBODIMENT

### [First Embodiment]

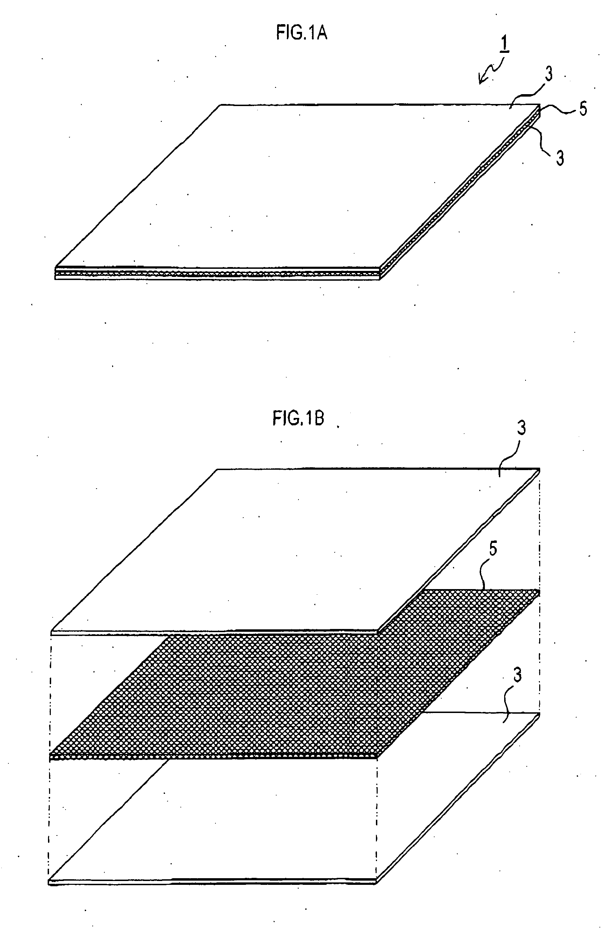

Referring to FIGS. 1A and 1B, a ceramic sheet 1 of the present embodiment has a stacked structure including a pair of flexible sheet layers 3 and a ceramic layer 5. More particularly, the ceramic sheet 1 has a three-layered structure in which the ceramic layer 5 is disposed between the pair of flexible sheet layers 3.

The flexible sheet layers 3 are made of various synthetic resin materials, plastic materials, elastomer materials and others which can be formed into a sheet. For example, the flexible sheet layers 3 are PET (polyethylene terephthalate) sheets, PEN (polyethylene naphthalate) sheets, PPS (polyphenylene sulfide) sheets, PVC (polyvinyl chloride) sheets, urethane sheets, polyimide sheets or others. The thickness of the flexible sheet layers 3 is preferably in a range of 0.005-0.5 mm, more preferably 0.01-0.3 mm. In the present embodiment, the flexible sheet layers 3 are PET sheets having a thickness of 0.085 mm and being tacky on one side.

The ceramic layer 5 is made of ceramic materials such as Ni-Zn ferrite, Mn-Zn ferrite, Mg-Zn ferrite, Ba ferrite, ferroxplana ferrite, Cu-Zn ferrite, alumina, silicon carbide, barium titanate, aluminum nitride, boron nitride, silicon nitride, magnesia, graphite and others. The ceramic layer 5 preferably has a thickness of 0.01-1 mm, more preferably, 0.01-0.3 mm, so that the ceramic sheet 1 can be easily bent and warped. In the present embodiment, the ceramic layer 5 is a sintered body of soft magnetic ferrite (e.g., Ni-Zn ferrite) having a thickness of 0.2 mm.

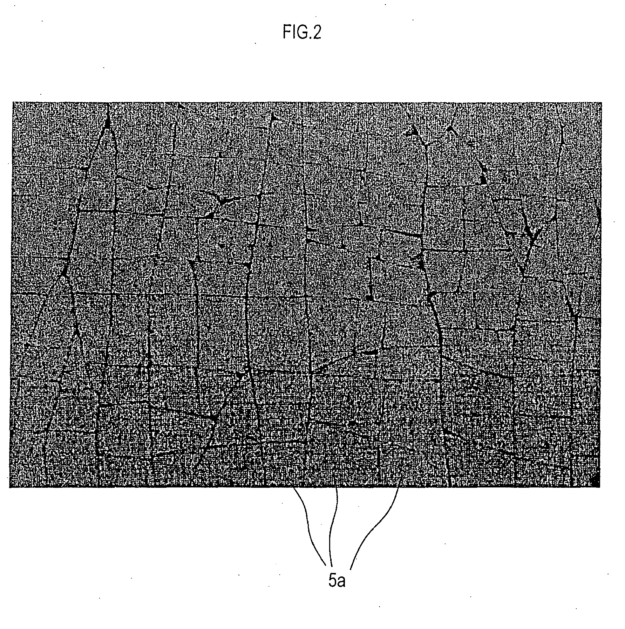

More particularly, as shown in FIG. 2, the ceramic layer 5 includes a plurality of ceramic pieces 5a arranged in a planar manner. The plurality of ceramic pieces 5a are different in size and shape, but primarily constitute a sheeted ceramic 5b. The sheeted ceramic 5b is split into the ceramic pieces 5a along irregular cracks which are produced by applying external force to the sheeted ceramic 5b.

In the present embodiment, the ceramic layer 5 is prepared as below.

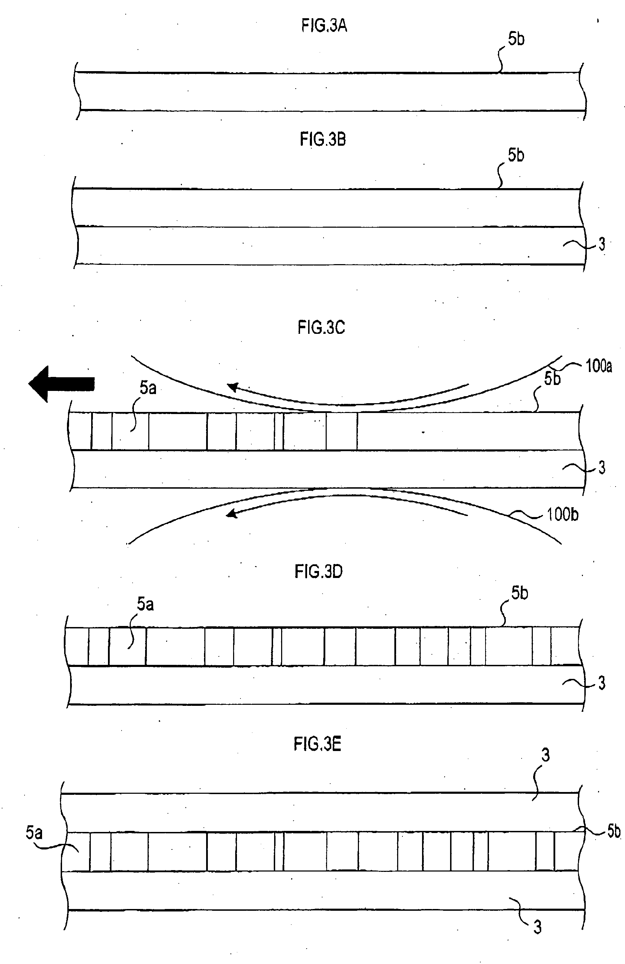

As shown in FIGS. 3A-3E, the sheeted ceramic 5b is a sheeted sintered ferrite in the present embodiment (see FIG. 3A). More particularly, the sheeted ceramic 5b has no incision for cracking the sheeted ceramic 5b formed on both sides of the sheeted ceramic 5b. That is, the sheeted ceramic 5b is flat as a whole and has a constant thickness (0.2 mm). One of the flexible sheet layers 3 is made adhere to the bottom surface of the sheeted ceramic 5b (see FIG. 3B).

Then, the stacked body including the flexible sheet layer 3 and the sheeted ceramic 5b is passed between a pair of rollers 100a and 100b facing each other to break the sheeted ceramic 5b, thereby producing the plurality of ceramic pieces 5a (see FIG. 3C).

When the stacked body is passed between the pair of rollers 100a and 100b, the sheeted ceramic 5b is forced to be bent along the curvature of the roller 100a which is brought into contact with the sheeted ceramic 5b. Thus, some parts of the sheeted ceramic 5b which cannot be bent along the curvature are cracked in irregular directions to be broken into small pieces (ceramic pieces 5a). Accordingly, after the stacked body is passed between the rollers 100a and 100b, each of the ceramic pieces 5a is in a finely broken state to an extent that no further breaking can be made.

The stacked body may be passed between the rollers 100a and 100b as many times as desired. The more times the stacked body is passed between the rollers 100a and 100b, the less large pieces remain in the stacked body. Thus, in order to split the sheeted ceramic 5b more finely, the stacked body is preferably passed between the rollers 100a and 100b more than once.

In the present embodiment, the stacked body of the flexible sheet layer 3 and the sheeted ceramic 5b is passed between the rollers 100a and 100b more than once and each time in different directions so that the bending direction of the stacked body is changed. If the bending direction of the stacked body is changed as such, directional properties in bending direction is not likely to be exhibited. Thus, the ceramic sheet 1 can be much easy to be bent.

After producing the ceramic pieces 5a as above (see FIG. 3D), the other of the flexible sheet layers 3 is made adhere to the top of the sheeted ceramic 5b, thereby completing a desired ceramic sheet 1 (see FIG. 3E).

In the present embodiment, the flexible sheet layers 3 adhere or are heat-sealed to the ceramic layer 5. In the present embodiment, an acrylic adhesive is employed as adhesive. Pressure-sensitive adhesive, thermosensitive adhesive, or adhesive used in various adhesive tapes and sheets may be employed as desired.

The aforementioned ceramic sheet 1, including the ceramic layer 5 made of soft magnetic ferrite, can be used as an electromagnetic wave shield or an electromagnetic absorber like a general ferrite sintered body. For example, the ceramic sheet 1 can be used against radiated noise generated from an electronic part and various cables.

The above ceramic sheet 1 includes the ceramic layer 5 containing the plurality of ceramic pieces 5a and the flexible sheet layers 3 stacked on each side of the ceramic layer 5. Since the stacked body can be easily bent, the whole ceramic sheet 1 is flexible and can be bent and warped. As compared to the case of using a highly rigid ferrite sintered body, there is a lot of flexibility in disposing the ceramic sheet 1. The ceramic sheet 1 can be disposed at a position where there is difficulty in disposing a conventional ferrite sintered body.

Specifically, the plurality of ceramic pieces 5a are irregular in shape, resulted from splitting the sheeted ceramic 5b along irregular cracks. The ceramic sheet 1 as such does not exhibit directional properties when being bent, unlike a conventional ceramic sheet containing ceramic pieces split along grid-like cracks. The ceramic sheet 1 is easy to be disposed along a curve or on an uneven surface.

That is, since the bending direction is not fixed to a certain direction, the ceramic sheet 1 can be easily disposed along a curve or on an uneven surface without paying excessive attention to the bending direction.

Moreover, the ceramic pieces 5a are not shrunk at the outer edges. Thus, although microscopic unevenness may be produced on fractured cross sections (outer edges of the ceramic pieces 5a) in the sheeted ceramic 5b, the adjacent ceramic pieces 5a can fit into each other. Accordingly, there is almost no gap, or only a very little gap, if there is, exists between the adjacent ceramic pieces 5a in the ceramic sheet 1. Hence, since not an excessive gap is produced, continuity in the ceramic layer 5 is not interrupted. The performance of the ceramic sheet 1 can be improved.

Moreover, if the sheeted ceramic 5b after grooved is split, a contact area between the ceramic pieces 5a is reduced by the grooves. On the other hand, in the ceramic sheet 1, a thickness of the sheeted ceramic 5b is effectively utilized to maximize a contact area between the ceramic pieces 5a. Accordingly, continuity in the ceramic layer 5 is not interrupted and the performance of the ceramic sheet 1 can be improved in this regard as well.

Moreover, in the ceramic sheet 1, the ceramic pieces 5a are produced by breaking fragile parts of the sheeted ceramic 5b. Accordingly, further breaking of the individual ceramic pieces 5a can be inhibited, thereby restricting alteration of the properties of the ceramic sheet 1.

Furthermore, irregular cracks produced by applying external force are formed after the sheeted ceramic 5b is made adhere to the flexible sheet layer 3. If the sheeted ceramic 5b is broken before the flexible sheet layer 3 is stacked on the sheeted ceramic 5b, gaps between the ceramic pieces 5a may be possibly expanded during the stack operation. Performance of the ceramic layer 5 may be deteriorated. If much attention needs to be paid for the stack operation so as not to cause performance deterioration, productivity may be decreased due to necessity of caution. If the cracks are formed by applying external force after the sheeted ceramic 5b adhere to the flexible sheet layer 3, production of gaps is inhibited between the ceramic pieces 5a without requiring excessive caution. The performance of the ceramic layer 5 can be improved without decreasing the productivity.

### [Second Embodiment]

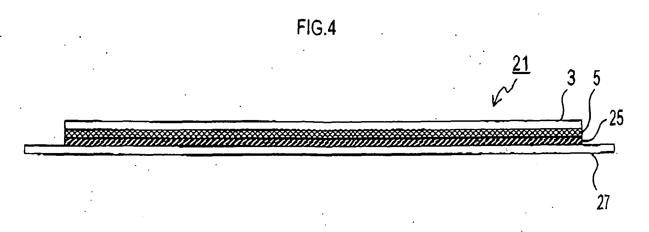

A ceramic sheet 21 shown in FIG. 4 has a stacked structure including the flexible sheet layer 3, the ceramic layer 5, and an adhesive layer 25 having a release paper 27. The adhesive layer 25 in the present embodiment uses the same adhesive as in the first embodiment. A two-sided adhesive tape may be employed as the adhesive layer.

Even the ceramic sheet 21 as such can achieve the same operation and effect as in the case of the first embodiment. Also, in a section of the ceramic sheet 21 where the ceramic layer 5 and the adhesive layer 25 come into direct contact, fine pieces produced when the ceramic layer 5 is broken are caught and held by the adhesive layer 25 to stay near the fracture part of the ceramic layer 5. Since the fine pieces do not drop off or move to be displaced to one section from the part near the facture part, performance of the ceramic sheet 21 is stable and can be easily maintained.

Furthermore, the ceramic sheet 21 can adhere to anywhere desired by removing the release paper 27 of the adhesive layer 25.

### [Third Embodiment]

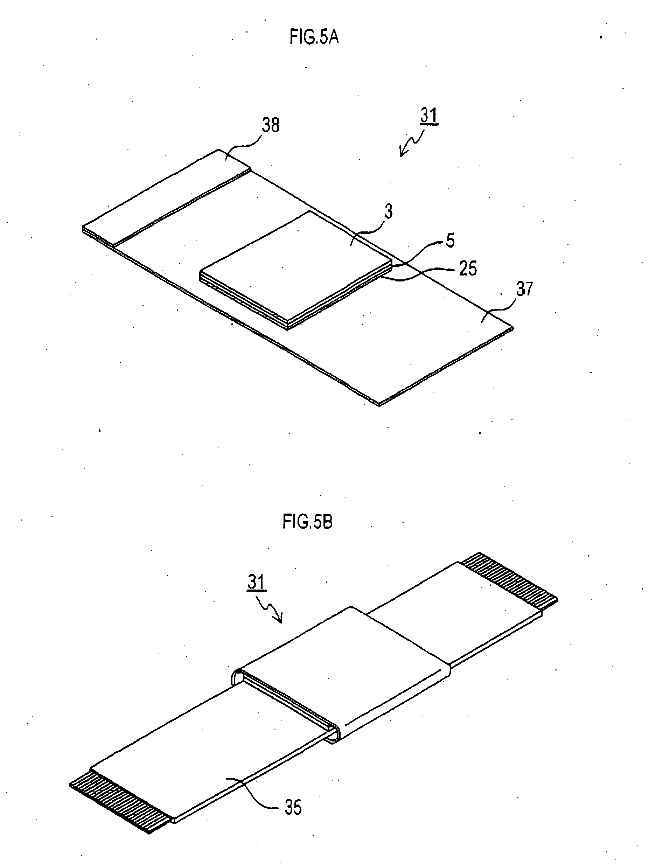

A ceramic sheet 31 shown in FIG. 5A is similar to the ceramic sheet 21 shown in FIG. 4 in that the both sheets have a stacked structure including the flexible sheet layer 3, the ceramic layer 5 and the adhesive layer 25. However, the ceramic sheet 31 further includes a band form 37 and an adhesion portion 38.

As shown in FIG. 5B, the ceramic sheet 31 structured as such can be attached to a flat cable 35 (or FPC (Flexible Printed Circuits) and others; the same applies hereinafter) by wrapping the band form 37 around the flat cable 35 and making the adhesion portion 38 adhere to the outer peripheral side of the band form 37. As a result, the ceramic sheet 31 can be used against radiated noise from the flat cable 35. [Fourth Embodiment]

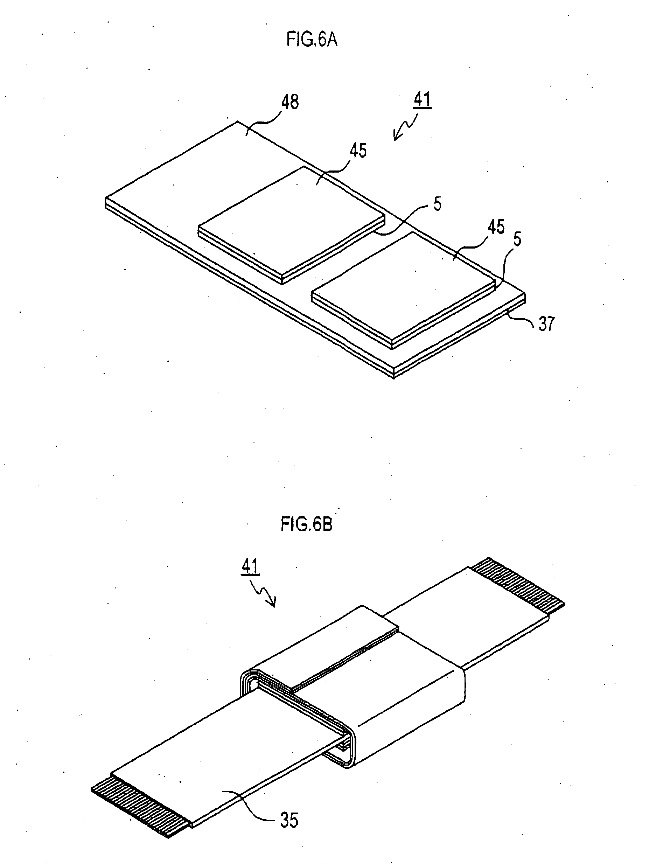

A ceramic sheet 41 shown in FIG. 6A has a stacked structure including the ceramic layer 5, the band form 37 and adhesive layers 45 and 48. The ceramic sheet 41 is similar to the ceramic sheet 31 shown in FIG. 5A in that the band form 37 is provided. However, while the ceramic sheet 31 has one stacked body including the flexible sheet layer 3, the ceramic layer 5 and the adhesive layer 25, the ceramic sheet 41 has two stacked bodies, each including the adhesive layer 45 and the ceramic layer 5.

As shown in FIG. 6B, the ceramic sheet 41 structured as such can be attached to the flat cable 35 by wrapping the band form 37 around the flat cable 35 and making the adhesive layers 45 and 48 adhere to the flat cable 35.

When the ceramic sheet 41 is attached to the flat cable 35, the flat cable 35 can be held between the two stacked bodies since the ceramic sheet 41 is provided with the two stacked bodies. Accordingly, the ceramic sheet 41 can better improve effect against radiated noise from the flat cable 35 than the ceramic sheet 31 including only one stacked body.

Moreover, the ceramic sheet 41 can be attached to the flat cable 35 by making the adhesive layer 45 directly adhere to the flat cable 35. Accordingly, the ceramic sheet 41 can inhibit the stacked bodies including the ceramic layer 5 from being displaced from the given attachment position to the flat cable 35. [Fifth Embodiment]

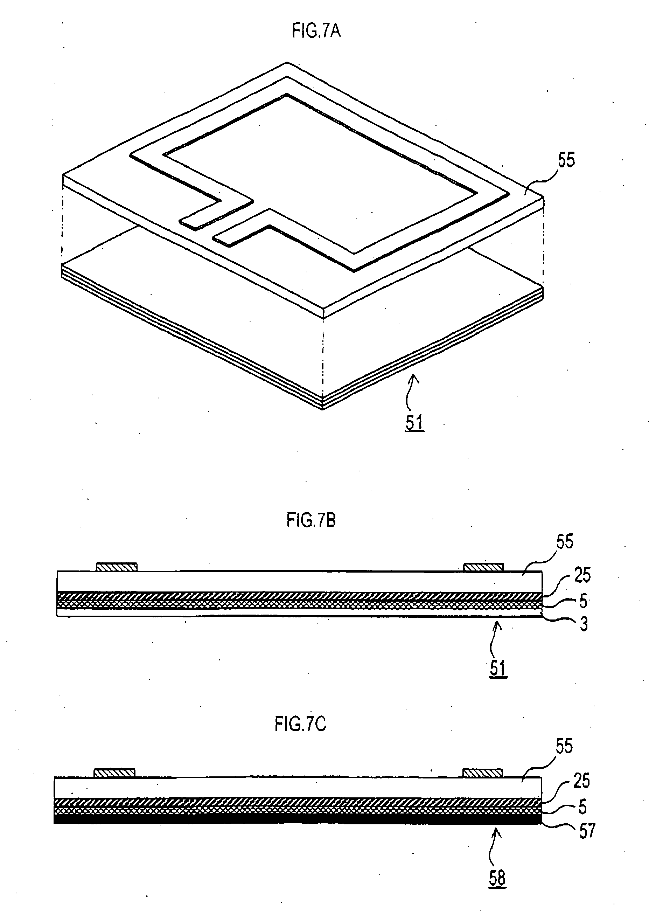

A ceramic sheet 51 shown in FIGS. 7A and 7B is attached to a RFID (Radio Frequency IDentification) antenna base 55. The ceramic sheet 51 has the same structure as the ceramic sheet 21 shown in FIG. 4 in that the ceramic sheet 51 has a stacked structure including the flexible sheet layer 3, the ceramic layer 5 and the adhesive layer 25.

If the ceramic sheet 51 as such is made adhere to the RFID antenna base 55, influence of metal around the RFID antenna base 55 can be avoided in communication using RFID. Thereby, the communication distance can be expanded.

A ceramic sheet 58 shown in FIG. 7C is a variation of the ceramic sheet 51, which employs a conductive layer 57 made of conductive material instead of the flexible sheet layer 3 included in the ceramic sheet 51. The ceramic sheet 58, like the ceramic sheet 51, is also used to adhere to the RFID antenna base 55.

For the conductive material, material produced by dispersing conductive filler such as metal powder, metal plating powder, carbon powder and others in matrix resin can be used. Or, a layer formed by applying metal coating to the surface of a flexible sheet by metal evaporation coating, spattering, ion plating, metal plating, coating with conductive material and others may be employed as the conductive layer 57. Or, the conductive layer 57 may be made from metallic foil such as aluminum foil, copper foil and others, or a metal plated woven cloth or unwoven cloth. The conductive layer 57 may be also made from metal mesh, metal net or carbon mesh.

Influence of metal around the RFID antenna base 55 can be avoided even by the ceramic sheet 58, in the same manner as by the ceramic sheet 51, in communication using RFID. The communication distance can be expanded. Specifically, shielding effect against electromagnetic wave can be improved by the conductive layer 57.

### [Sixth Embodiment]

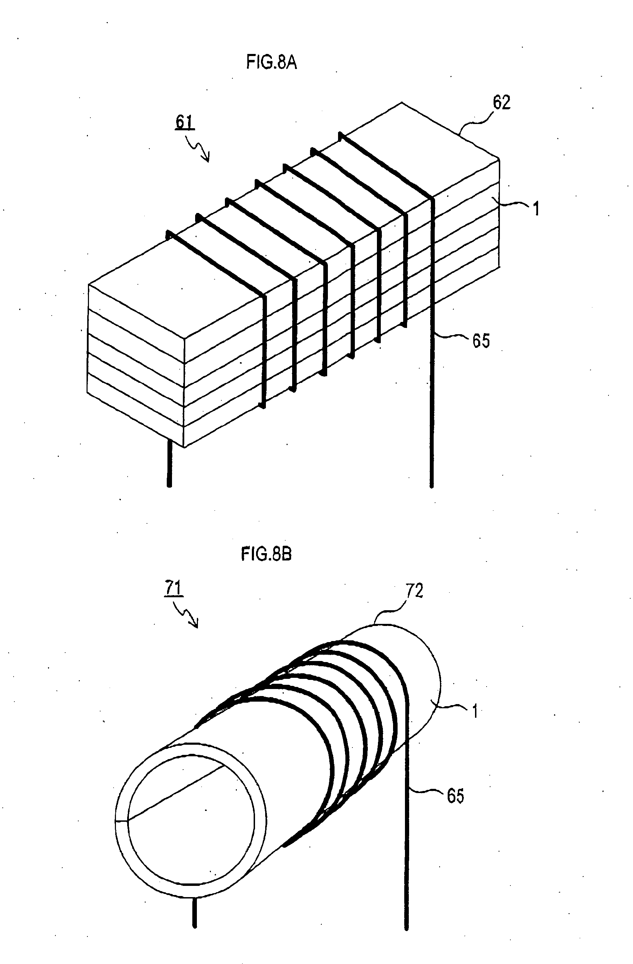

An antenna 61 shown in FIG. 8A has a structure in which a copper wire 65 is coiled around the outer periphery of a magnetic core 62. The magnetic core 62 is formed by stacking five strip-shaped ceramic sheets 1 on top of each other.

Conventionally, this type of antenna uses a ferrite sintered body as a magnetic core. However, the ferrite sintered body is easy to break when given an impact. Thus, when a product incorporating the antenna is dropped, the magnetic core is broken thereby causing alteration to the properties of the magnetic core. This may result in deterioration of antenna performance.

The ceramic sheet 1 including the magnetic core 62 has been already broken at fragile parts of the ceramic layer 5 when producing irregular cracks. Accordingly, the ceramic layer 5 is rarely broken further even if an impact as above is applied. Accordingly, the properties of the magnetic core 62 are not likely to be altered even in the event of dropping a product incorporating the antenna 61. Deterioration in performance of the antenna 61 can be avoided.

Another example of a conventional antenna uses a magnetic core made of magnetic resin material. The magnetic resin material is prepared by compounding magnetic filler with resin. However, a magnetic core made of such magnetic resin material is inferior to a ferrite sintered body in magnetic properties.
Satisfactory performance is not always achieved.

The ceramic layer 5 of the ceramic sheet 1 is formed from a ferrite sintered body. The magnetic core 62 formed by the ceramic sheet 1 exhibits, unlike the magnetic core made of magnetic resin material, performance close to the ferrite sintered body. Accordingly, the magnetic core 62 has better magnetic properties than the magnetic core made of magnetic resin material. Stability of the product can be improved and miniaturization of the product can be achieved.

The magnetic core 62 shown in FIG. 8A is formed by stacking five strip-shaped ceramic sheets 1. However, as many sheets as desired can be stacked as long as the size of the stack is appropriate for use as a magnetic core for an antenna. Also, not only one type but a plurality of types of ceramic sheets which are different in their properties may be stacked. For example, two types of ceramic sheets may be alternately stacked.

### [Seventh Embodiment]

An antenna 71 shown in FIG. 8B, like the antenna 61, has a structure in which the copper wire 65 is coiled around the outer periphery of a magnetic core 72. The magnetic core 72 has a cylinder structure in which one sheet of the ceramic sheet 1 is rolled into a cylinder such that facing edges of the ceramic sheet 1 are bonded together.

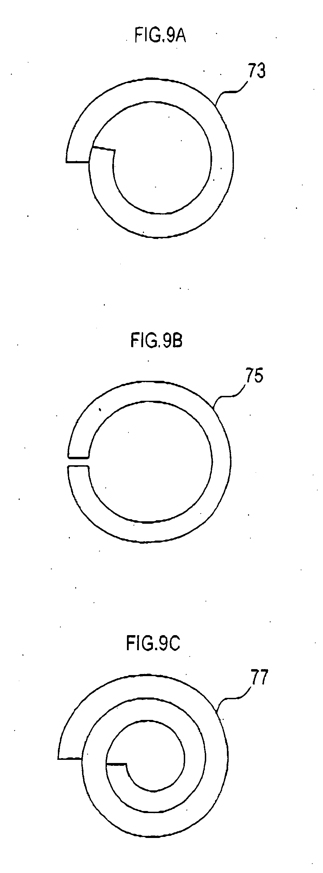

FIGS. 9A-9C show cross sectional views of variations of magnetic cores having a cylinder structure like the magnetic core 72 but formed in different rolling manners. A magnetic core 73 shown in FIG. 9A is formed by rolling the ceramic sheet 1 so that the edge parts are overlapped. A magnetic core 75 shown in FIG. 9B is formed by rolling the ceramic sheet 1 so that the facing edges are not brought into contact with each other. A magnetic core 77 shown in FIG. 9C is formed by rolling the ceramic sheet 1 into a spiral shape.

The same effect as in the antenna 61 can be obtained even in the antenna provided with the magnetic core 71, 73, 75 or 77.

### [Other Embodiments]

The embodiments of the present invention have been described in the above. However, the present invention should not be limited by the above particular embodiments, and can be practiced in various manners.

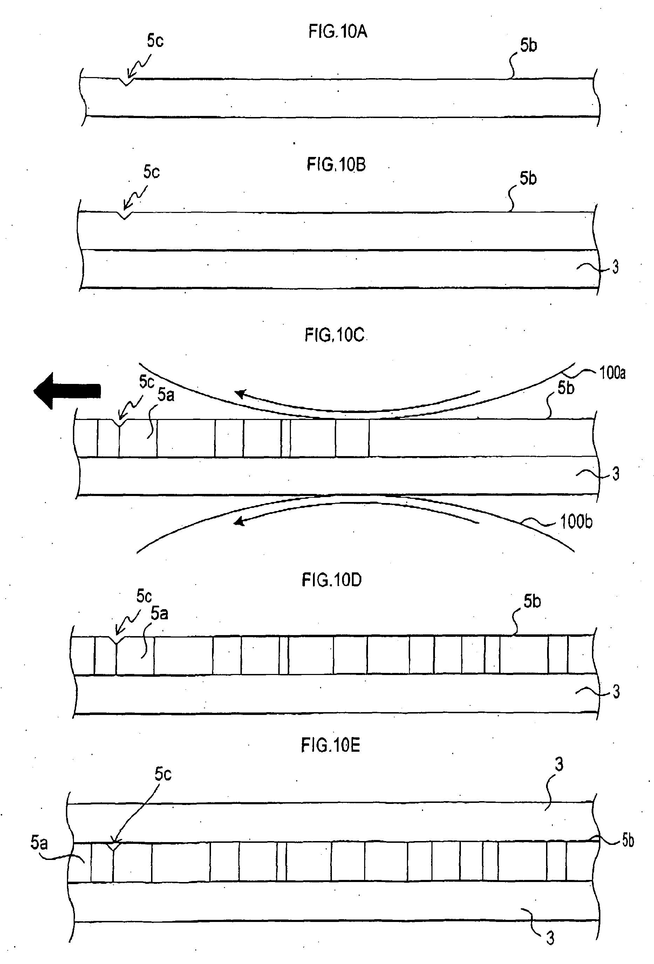

For instance, in the ceramic sheet 1 of the above first embodiment, the ceramic layer 5 is formed by cracking the sheeted ceramic 5b in which no incision is formed. However, as shown in FIGS. 10A-10E, at least one incision 5c for cracking the sheeted ceramic 5b may be formed on at least one side of the sheeted ceramic 5b, and the ceramic sheet 1 may be produced in the same manner as in the first embodiment.

In the above first embodiment, the flexible sheet layer 3 is adhered only to the bottom surface of the sheeted ceramic 5b and the stacked body is passed between the pair of rollers 100a and 100b to produce the ceramic pieces 5a. However, the flexible sheet layer 3 can be adhered to both sides of the sheeted ceramic 5b and the stacked body may be passed between the pair of rollers 100a and 100b to produce the ceramic pieces 5a.

In the ceramic sheet of the above embodiments, the ceramic layer 5 and the flexible sheet layer 3 are substantially the same in size. However, the ceramic layer 5 may be disposed between flexible sheet layers 3 larger than the ceramic layer 5, and the peripheral edge of the flexible sheet layers 3 may be directly heat sealed. In this manner, the ceramic layer 5 is enveloped in the flexible sheet layers 3 and not exposed from the peripheral edge of the ceramic sheet. Much reliable protection can be provided to the ceramic layer 5.

The ceramic sheets according to the first to fourth embodiments may include a conductive layer made of conductive material as mentioned above. In this manner, since the conductive layer functions as an electromagnetic shield layer, radiated noise can be effectively suppressed due to synergic effect with the ceramic layer 5.

The ceramic sheets of the above embodiments may include a heat-conductive layer made of heat-conductive material. The heat-conductive material may be, for example, a material obtained by dispersing heat-conductive filler like alumina in matrix resin. Thereby, when the ceramic sheet including the heat-conductive layer is attached to an electronic part, heat dissipation from the electronic part can be induced. At the same time, the ceramic sheet can be used against radiation noise from the electronic part.

In the ceramic sheets of the above embodiments, not only one ceramic layer 5 but a plurality of ceramic layers 5 may be provided. Thereby, effect by the ceramic layer 5 such as shielding effect against electromagnetic wave can be enhanced. Also, the plurality of ceramic layers 5 may be of different materials. For example, one of the ceramic layers 5 may be formed into a magnetic body which shields electromagnetic wave at relatively low frequency while the other of the ceramic layers 5 may be formed into a dielectric body which shields electromagnetic wave at relatively high frequency. In this manner, electromagnetic wave in a broader frequency range may be shielded.

The ceramic sheets of the above embodiments may include a damping and heat-conductive layer. The damping and heat-conductive layer is made of a composite material obtained by compounding heat-conductive filler with elastomer material superior in damping effect. Thereby, when the ceramic sheet including the damping and heat-conductive layer is attached to an electronic part, not only radiation noise and heat from the electronic part but also vibration and impact transmitted to the electronic part can be attenuated. Protection is provided to the electronic part.

The ceramic sheets of the above embodiments may include an impact-resistant layer made of impact-resistant material. The impact-resistant layer is made of elastomer material superior in impact-resistance. Thereby, when the ceramic sheet including the impact-resistant layer is attached to an electronic part, not only radiation noise from the electronic part but also damage to the electronic part possibly caused by impact transmitted to the electronic part can be suppressed.

In the ceramic sheets of the above embodiments, the ceramic layer 5 is made of Ni-Zn ferrite. However, other ceramic material may be used for the ceramic layer 5. For example, the ceramic layer 5 including at least one of Mn-Zn ferrite, Mg-Zn ferrite, Ba ferrite, ferroxplana ferrite and Cu-Zn ferrite can exhibit excellent properties as a magnetic body. The ceramic layer 5 including at least one of alumina, silicon carbide and barium titanate exhibits excellent properties as a dielectric body. The ceramic layer 5 including at least one of aluminum nitride, boron nitride, silicon nitride, magnesia and graphite exhibits excellent properties as a heat-conductive body.

In the above embodiments, particular examples are given for the shape of the ceramic sheet and the thickness of the ceramic layer 5. However, these conditions can be arbitrarily changed within a range in which the function as the ceramic sheet is not to be lost.

## Claims

1. A ceramic sheet having at least one ceramic layer, the at least one ceramic layer including a plurality of ceramic pieces, at least a part of the plurality of ceramic pieces being formed by cracking a sintered ceramic plate, which at least partially has a flat part, at the flat part of the sintered ceramic plate.

2. The ceramic sheet according to claim 1, wherein the flat part is a part having a constant thickness in the sintered ceramic plate.

3. The ceramic sheet according to claim 1, wherein the flat part is a part having no incision formed in the sintered ceramic plate.

4. The ceramic sheet according to one of claims 1-3,
wherein the plurality of ceramic pieces are formed by sandwiching the sintered ceramic plate between at least two another layers and cracking the sintered ceramic plate by applying external force to the sintered ceramic plate.

5. The ceramic sheet according to one of claims 1-3,
wherein the plurality of ceramic pieces are formed by adhering the sintered ceramic plate to at least another layer and cracking the sintered ceramic plate by applying external force to the sintered ceramic plate.

6. The ceramic sheet according to one of claims 1-5,
wherein the plurality of ceramic pieces are formed by cracking the sintered ceramic plate by causing the sintered ceramic plate to pass at least one roller such that external force is applied to at least one side of the sintered ceramic plate from the at least one roller.

7. The ceramic sheet according to claim 6, wherein the sintered ceramic plate is caused to pass the at least one roller more than once and each time in different directions.

8. The ceramic sheet according to one of claims 1-7,
wherein the sintered ceramic plate includes as material at least one of Ni-Zn ferrite, Mn-Zn ferrite, Mg-Zn ferrite, Ba ferrite, Ferroxplana ferrite, Cu-Zn ferrite, alumina, silicon carbide, barium titanate, aluminum nitride, boron nitride, silicon nitride, magnesia and graphite.

9. The ceramic sheet according to one of claims 1-8 having at least one another layer stacked on the at least one ceramic layer.

10. The ceramic sheet according to claim 9, wherein the at least one another layer includes an adhesive layer made of adhesive material.

11. The ceramic sheet according to claim 9 or 10,
wherein the at least one another layer includes a conductive layer made of conductive material.

12. The ceramic sheet according to one of claims 9-11,
wherein the at least one another layer includes a heat-conductive layer made of heat-conductive material.

13. The ceramic sheet according to one of claims 9-12,
wherein the at least one another layer includes a damping layer made of damping material.

14. The ceramic sheet according to one of claims 9-13,
wherein the at least one another layer includes an impact-resistant layer made of impact-resistant material.

15. A method of producing a ceramic sheet having at least one ceramic layer, the method comprising a step of forming the at least one ceramic layer including a plurality of ceramic pieces by cracking a sintered ceramic plate, which at least partially has a flat part, at at least the flat part of the sintered ceramic plate.
